# FASCICULE DE BREVET EUROPEEN

(11) **EP 3 657 551 B1**
(45) Date de publication et mention de la délivrance du brevet: **28.04.2021**
(21) Numéro de dépôt: 19209495.1
(22) Date de dépôt: 15.11.2019
(51) Int. Cl.: H01L 31/0216, H01L 31/048, H02S 20/21

(54) **DISPOSITIF PHOTOVOLTAÏQUE COMPORTANT AU MOINS UNE COUCHE DE REVÊTEMENT SUR AU MOINS UN MODULE PHOTOVOLTAÏQUE AVEC INDICATEUR D'USURE**
PHOTOVOLTAIKVORRICHTUNG MIT MINDESTENS EINER SCHICHT AUF MINDESTENS EINEM PHOTOVOLTAIKMODUL MIT VERSCHLEISSANZEIGE
PHOTOVOLTAIC DEVICE COMPRISING AT LEAST ONE COATING LAYER ON AT LEAST ONE PHOTOVOLTAIC MODULE WITH WEAR INDICATOR

(30) Priorité: 26.11.2018 FR 1871853
(43) Date de publication de la demande: 27.05.2020
(73) Titulaire: Commissariat à l'énergie atomique et aux énergies alternatives, 75015 Paris (FR)
(72) Inventeur: LEFILLASTRE, Paul, 38054 Grenoble Cedex 09 (FR); GAUME, Julien, 38054 Grenoble Cedex 09 (FR)
(74) Mandataire: Brevalex

(56) Documents cités:
- FR-A1- 3 024 282
- FR-A1- 3 043 840
- FR-A1- 3 043 841

## Description

### DOMAINE TECHNIQUE

La présente invention se rapporte au domaine des modules photovoltaïques, qui comportent un ensemble de cellules photovoltaïques reliées entre elles électriquement, et préférentiellement des cellules photovoltaïques dites « cristallines », c'est-à-dire qui sont à base de silicium monocristallin ou multicristallin.

L'invention peut être mise en œuvre pour de nombreuses applications, étant particulièrement concernée par les applications dans lesquelles les modules photovoltaïques sont susceptibles de subir des détériorations, ou plus généralement des modifications, de leurs faces avant. Elle peut ainsi notamment être appliquée pour des modules photovoltaïques intégrés dans des véhicules (modules de type VIPV pour « Vehicle Integrated Photovoltaics » en anglais), notamment des voitures, des bus ou des bateaux, tout particulièrement des ponts de bateaux, dans des bâtiments (modules de type BIPV pour « Building Integrated Photovoltaics » en anglais), notamment des habitats ou locaux industriels (tertiaires, commerciaux, ...), par exemple pour la réalisation de leurs toitures, dans du mobilier urbain, par exemple pour de l'éclairage public, la signalisation routière, la recharge de voitures électriques, les trottoirs, ou encore pour la réalisation de routes solaires, entre autres.

L'invention propose ainsi un dispositif photovoltaïque comportant au moins une couche de revêtement avec indicateur(s) d'usure disposée sur un ou plusieurs modules photovoltaïques, un procédé de fabrication d'un tel dispositif, ainsi qu'un procédé d'utilisation du dispositif photovoltaïque.

### ÉTAT DE LA TECHNIQUE ANTÉRIEURE

Un module photovoltaïque est un assemblage de cellules photovoltaïques disposées côte à côte entre une première couche transparente formant une face avant du module photovoltaïque et une seconde couche formant une face arrière du module photovoltaïque.

La première couche formant la face avant du module photovoltaïque est avantageusement transparente pour permettre aux cellules photovoltaïques de recevoir un flux lumineux. Elle est traditionnellement réalisée en une seule plaque de verre, présentant une épaisseur typiquement comprise entre 2 et 4 mm, classiquement de l'ordre de 3 mm.

La deuxième couche formant la face arrière du module photovoltaïque (ou « backsheet » en anglais) peut quant à elle être réalisée en un polymère, généralement en poly(éthylène-acétate de vinyle) (EVA), polyoléfine thermoplastique (TPO), polyoléfine réticulable (POE), ionomère, silicone, poly(butyral vinylique) (PVB) d'encapsulation (d'une épaisseur typiquement comprise entre 0,2 et 1 mm) des cellules et une feuille extérieure (ou « backsheet » en anglais) à base de verre, de métal ou de plastique, entre autres. Elle est souvent formée par une structure polymérique à base d'un polymère isolant électrique, par exemple du type polytéréphtalate d'éthylène (PET) ou polyamide (PA), pouvant être protégée par une ou des couches à base de polymères fluorés, comme le polyfluorure de vinyle (PVF) ou le polyfluorure de vinylidène (PVDF), et ayant une épaisseur de l'ordre de 200 à 400 µm.

Les cellules photovoltaïques peuvent être reliées électriquement entre elles par des éléments de contact électrique avant et arrière, appelés conducteurs de liaison, et formés par exemple par des bandes de cuivre étamé, respectivement disposées contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques. Dans certains cas, tous les contacts peuvent également se faire en face arrière des cellules uniquement.

Par ailleurs, les cellules photovoltaïques, situées entre les première et deuxième couches formant respectivement les faces avant et arrière du module photovoltaïque, peuvent être encapsulées. De façon classique, l'encapsulant choisi correspond à un polymère du type élastomère (ou caoutchouc), et peut par exemple consister en l'utilisation de deux couches (ou films) de poly(éthylène-acétate de vinyle) (EVA) entre lesquelles sont disposées les cellules photovoltaïques et les conducteurs de liaison des cellules. L'encapsulant peut également correspondre à une polyoléfine thermoplastique (TPO), une polyoléfine réticulable (POE), un ionomère, un silicone, du poly(butyral vinylique) (PVB). Chaque couche d'encapsulant peut présenter une épaisseur d'au moins 0,2 mm et un module de Young typiquement compris entre 2 et 400 MPa à température ambiante.

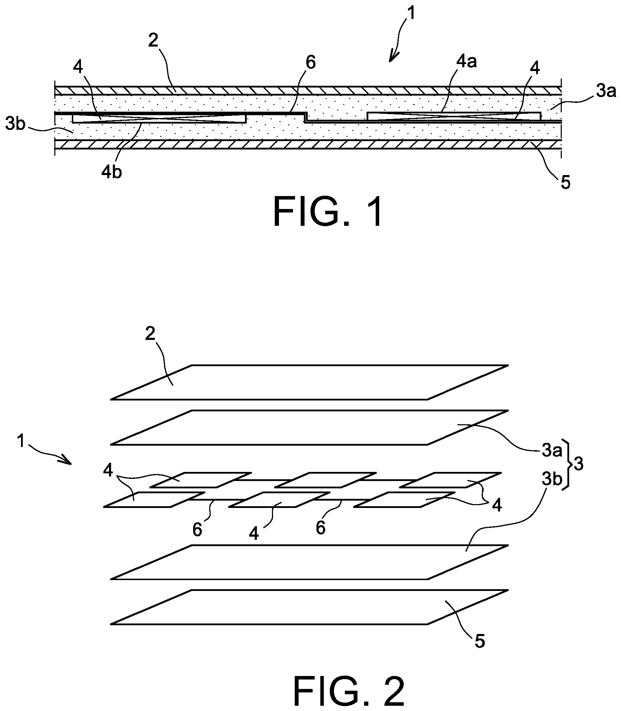

On a ainsi représenté partiellement et schématiquement, respectivement en coupe sur la figure 1 et en vue éclatée sur la figure 2, un exemple classique de module photovoltaïque 1 comportant des cellules photovoltaïques 4 cristallines.

Comme décrit précédemment, le module photovoltaïque 1 comporte une face avant 2, généralement réalisée en verre trempé transparent d'épaisseur d'environ 3 mm, et une face arrière 5, par exemple constituée par une feuille polymère, opaque ou transparente, monocouche ou multicouche, ayant un module de Young supérieur à 400 MPa à température ambiante.

Entre les faces avant 2 et arrière 5 du module photovoltaïque 1 se situent les cellules photovoltaïques 4, reliées électriquement entre elles par des conducteurs de liaison 6 et encapsulées entre deux couches avant 3a et arrière 3b de matériau d'encapsulation formant toutes les deux un ensemble encapsulant 3.

De façon habituelle, le procédé de réalisation du module photovoltaïque 1 comporte une étape dite de lamination sous vide des différentes couches décrites précédemment, à une température supérieure ou égale à 120°C, voire 140°C, voire encore 150°C, et inférieure ou égale à 170°C, typiquement comprise entre 145 et 160°C, et pendant une durée du cycle de lamination d'au moins 10 minutes, voire 15 minutes.

Pendant cette étape de lamination, les couches de matériau d'encapsulation 3a et 3b fondent et viennent englober les cellules photovoltaïques 4, en même temps que l'adhérence se crée à toutes les interfaces entre les couches, à savoir entre la face avant 2 et la couche avant de matériau d'encapsulation 3a, la couche de matériau d'encapsulation 3a et les faces avant 4a des cellules photovoltaïques 4, les faces arrière 4b des cellules photovoltaïques 4 et la couche arrière de matériau d'encapsulation 3b, et la couche arrière de matériau d'encapsulation 3b et la face arrière 5 du module photovoltaïque 1. Le module photovoltaïque 1 obtenu est ensuite le plus souvent encadré, typiquement par le biais d'un profilé en aluminium.

Une telle structure est maintenant devenue un standard qui possède une résistance mécanique importante grâce à l'utilisation d'une face avant 2 en verre épais, lui permettant dans la majorité des cas de respecter les normes IEC 61215 et IEC 61730.

Néanmoins, un tel module photovoltaïque 1 selon la conception classique de l'art antérieur peut être facilement détérioré lors de son utilisation dans certaines applications, par exemple lors d'un contact régulier sur le module, comme lors d'une utilisation sur un pont de bateau ou une route par exemple. Le plus souvent, cette détérioration est irrémédiable, et alors il est généralement nécessaire de changer l'ensemble du module photovoltaïque afin de retrouver la fonctionnalité souhaitée.

Aussi, il existe un besoin pour permettre de préserver la fonctionnalité souhaitée d'un module photovoltaïque, notamment sa capacité à recevoir le flux lumineux de façon optimale, indépendamment de son utilisation, et en particulier une solution pour garantir son fonctionnement normal même en cas de détérioration, notamment de sa face avant recevant le flux lumineux
Un dispositif photovoltaïque comportant un ou plusieurs modules photovoltaïques et au moins une couche de revêtement disposée sur le ou chaque module photovoltaïque est décrit dans le document FR 3 043 841 A1.

### EXPOSÉ DE L'INVENTION

L'invention a pour but de remédier au moins partiellement aux besoins mentionnés précédemment et aux inconvénients relatifs aux réalisations de l'art antérieur.

L'invention a ainsi pour objet, selon l'un de ses aspects, un dispositif photovoltaïque selon la revendication 1.

Le terme « transparent » signifie que le matériau de la première couche formant la face avant du module photovoltaïque est au moins partiellement transparent à la lumière visible, laissant passer au moins environ 80 % de cette lumière.

En outre, par le terme « encapsulant » ou « encapsulé », il faut comprendre que la pluralité de cellules photovoltaïques est disposée dans un volume, par exemple hermétiquement clos vis-à-vis des liquides, au moins en partie formé par au moins deux couches de matériau d'encapsulation, réunies entre elles après lamination pour former l'ensemble encapsulant.

En effet, initialement, c'est-à-dire avant toute opération de lamination, l'ensemble encapsulant est constitué par au moins deux couches de matériau d'encapsulation, dites couches de cœur, entre lesquelles la pluralité de cellules photovoltaïques est encapsulée. Toutefois, pendant l'opération de lamination des couches, les couches de matériau d'encapsulation fondent pour ne former, après l'opération de lamination, qu'une seule couche (ou ensemble) solidifiée dans laquelle sont noyées les cellules photovoltaïques.

Grâce à l'invention, il peut ainsi être possible de disposer d'une couche de revêtement qui constitue un prolongement de la face avant d'un module photovoltaïque et permet de recevoir un flux lumineux, cette couche pouvant par exemple être une couche sacrificielle susceptible d'être détériorée sans conséquence sur le fonctionnement du module. Ainsi, il n'est plus nécessaire de changer l'ensemble d'un module photovoltaïque en cas de modification, notamment de détérioration. La couche de revêtement peut être remise « à neuf» régulièrement. Il peut même être possible de modifier la couleur et/ou l'esthétisme d'un module photovoltaïque sans avoir à le changer. La présence d'un ou de plusieurs indicateurs d'usure permet également de réaliser le ponçage sans risque de détérioration du ou des modules photovoltaïques, en particulier de leur face avant. En effet, le ou les indicateurs d'usure permettent de renseigner sur l'épaisseur restante de la couche de revêtement et d'éviter de poncer au-delà de l'épaisseur minimale critique de la couche de revêtement en dessous de laquelle l'intégrité du ou des modules photovoltaïques n'est plus assurée.

Le dispositif photovoltaïque selon l'invention peut en outre comporter l'une ou plusieurs des caractéristiques suivantes prises isolément ou suivant toutes combinaisons techniques possibles.

Ladite au moins une couche de revêtement peut être ponçable, et ledit au moins un indicateur d'usure peut former un témoin limite de ponçage. Ainsi, la couche de revêtement peut présenter des propriétés lui permettant d'être ponçable, voire usinable, voire brossable, voire régénérable (autrement dit, elle peut être fabriquée de nouveau par l'ajout d'une ou plusieurs autres couches).

Par ailleurs, selon une première variante, ledit au moins un indicateur d'usure peut être positionné sur la première couche du ou de chaque module photovoltaïque au niveau d'un bord de la première couche.

Ledit au moins un indicateur d'usure peut notamment être fixé, notamment par collage, sur la ou les premières couches, puis recouvert par ladite au moins une couche de revêtement.

Selon une deuxième variante, le dispositif peut comporter au moins deux modules photovoltaïques, deux modules photovoltaïques adjacents étant espacés l'un de l'autre par un espace de séparation, une ou plusieurs couches de revêtement superposées étant disposée(s) sur la première couche de chaque module photovoltaïque et dans l'espace de séparation entre deux modules photovoltaïques adjacents, et ledit au moins un indicateur d'usure peut être positionné dans le ou les espaces de séparation. L'épaisseur dudit au moins un indicateur d'usure peut être supérieure à l'épaisseur desdits au moins deux modules photovoltaïques.

Par ailleurs, ledit au moins un indicateur d'usure peut être non superposé à une cellule photovoltaïque pour éviter d'ombrager ladite cellule photovoltaïque.

En outre, ledit au moins un indicateur d'usure peut être de forme conique. De cette façon, un taux d'usure proportionnel à la surface d'une coupe transversale de la forme conique peut être repéré.

En outre, le ou les matériaux de ladite au moins une couche de revêtement peuvent être différents du ou des matériaux de la première couche du ou de chaque module photovoltaïque. De plus, ladite au moins une couche de revêtement peut comporter un matériau polymère thermodurcissable, et peut présenter une épaisseur comprise entre 100 µm et 2 cm, notamment entre 1 mm et 1cm.

Par ailleurs, le matériau polymère thermodurcissable de ladite au moins une couche de revêtement peut présenter un module d'Young supérieur à 1 GPa à 25°C. De plus, le matériau polymère thermodurcissable de ladite au moins une couche de revêtement peut être choisi parmi les polyuréthanes, les résines acryliques et les résines époxy. En outre, ladite au moins une couche de revêtement n'est avantageusement pas constituée par un matériau composite comprenant des fibres de renfort mécanique.

Par ailleurs, selon une première variante, le dispositif peut comporter un unique module photovoltaïque, une ou plusieurs couches de revêtement superposées étant disposée(s) sur la première couche du module photovoltaïque.

Avantageusement, la ou les couches de revêtement peuvent présenter une longueur et une largeur égales ou supérieures à la longueur et à la largeur de la première couche du module photovoltaïque. La ou les couches de revêtement peuvent donc s'étendre d'un bord à l'autre de la première couche du module photovoltaïque. Ainsi, la ou les couches de revêtement peuvent recouvrir totalement la première couche du module photovoltaïque. Toutefois, l'épaisseur de la ou les couches de revêtement peut être variable, et notamment différente de l'épaisseur de la première couche du module photovoltaïque. En cas d'une pluralité de couches de revêtement, les épaisseurs des couches de revêtement superposées l'une à l'autre peuvent être identiques ou préférentiellement différentes.

Selon une deuxième variante, le dispositif peut comporter au moins deux modules photovoltaïques, deux modules photovoltaïques adjacents étant espacés l'un de l'autre par un espace de séparation, une ou plusieurs couches de revêtement superposées étant disposée(s) sur la première couche de chaque module photovoltaïque et dans l'espace de séparation entre deux modules photovoltaïques adjacents.

Avantageusement, la ou les couches de revêtement peuvent présenter une longueur et une largeur égales ou supérieures à la somme des longueurs et à la somme des largeurs des premières couches des modules photovoltaïques et des espaces de séparation entre deux modules adjacents. La ou les couches de revêtement peuvent donc s'étendre d'un bord à l'autre de l'ensemble des premières couches des modules photovoltaïques. Ainsi, la ou les couches de revêtement peuvent recouvrir totalement les premières couches des modules photovoltaïques. Toutefois, l'épaisseur de la ou les couches de revêtement peut être variable, et notamment différente de l'épaisseur des premières couches des modules photovoltaïques. En cas d'une pluralité de couches de revêtement, les épaisseurs des couches de revêtement superposées l'une à l'autre peuvent être identiques ou préférentiellement différentes.

Par ailleurs, ladite au moins une couche de revêtement peut être structurée, comportant un motif en relief conférant à ladite au moins une couche de revêtement une rugosité.

La structuration de ladite au moins une couche de revêtement peut par exemple permettre d'apporter une fonction d'accroche.

En outre, le dispositif peut comporter au moins une première couche de revêtement et une deuxième couche de revêtement, la première couche de revêtement étant située entre la deuxième couche de revêtement et la première couche du ou de chaque module photovoltaïque. L'épaisseur de la première couche de revêtement au-dessus de la première couche du ou de chaque module photovoltaïque peut être notamment inférieure à l'épaisseur de la deuxième couche de revêtement.

De plus, le dispositif peut comporter en outre au moins une couche fonctionnelle, notamment une couche d'accroche, antidérapante et/ou colorée, réalisée en un matériau différent de celui de ladite au moins une couche de revêtement. Ladite au moins une couche fonctionnelle peut être disposée sur ladite au moins une couche de revêtement, laquelle est alors située entre ladite au moins une couche fonctionnelle et la ou les premières couches du ou des modules photovoltaïques.

Par ailleurs, la première couche du ou des modules photovoltaïques peut être réalisée en verre et/ou en au moins un matériau polymère. Elle peut présenter une épaisseur inférieure ou égale à 1,1 mm.

La première couche du ou des modules photovoltaïques peut encore être réalisée en au moins un matériau polymère, notamment choisi parmi : le polycarbonate (PC), le polyméthacrylate de méthyle (PMMA), le polytéréphtalate d'éthylène (PET), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytetrafluoroéthylène (PTFE) et/ou le polychlorotrifluoroéthylène (PCTFE).

La deuxième couche du ou des modules photovoltaïques peut être réalisée en verre, métal ou plastique, entre autres. Elle peut par exemple être formée par une structure polymérique à base d'un polymère isolant électrique, par exemple du type polytéréphtalate d'éthylène (PET), polyamide (PA) ou polypropylène (PP) pouvant être protégée par une ou des couches à base de polymères fluorés, comme le polyfluorure de vinyle (PVF) ou le polyfluorure de vinylidène (PVDF).

La deuxième couche peut présenter une épaisseur comprise entre 150 et 600 µm.

De plus, l'ensemble encapsulant peut être réalisé à partir d'au moins un matériau polymère choisi parmi : les copolymères d'acides, les ionomères, le poly(éthylène-acétate de vinyle) (EVA), les acétals de vinyle , tels que les polyvinylbutyrals (PVB), les polyuréthanes, les chlorures de polyvinyle, les polyéthylènes, tels que les polyéthylènes linéaires basse densité, les polyoléfines élastomères de copolymères, les copolymères d'a-oléfines et des α-, β- esters d'acide carboxylique à éthylénique, tels que les copolymères éthylène-acrylate de méthyle et les copolymères éthylène-acrylate de butyle, les élastomères de silicone et/ou les résines époxy, entre autres.

De préférence, l'ensemble encapsulant peut être réalisé à partir de deux couches de poly(éthylène-acétate de vinyle) (EVA) d'épaisseur au moins égal à 200 µm, entre lesquelles sont disposées les cellules photovoltaïques.

Les cellules photovoltaïques peuvent être choisies parmi : des cellules photovoltaïques homojonction ou hétérojonction à base de silicium monocristallin (c-Si) et/ou multi-cristallin (mc-Si), et/ou des cellules photovoltaïques comprenant au moins un matériau parmi le silicium amorphe (a-Si), le silicium microcristallin (µC-Si), le tellurure de cadmium (CdTe), le cuivre-indium séléniure (CIS) et le cuivre-indium/gallium diséléniure (CIGS), entre autres.

Par ailleurs, les cellules photovoltaïques peuvent présenter une épaisseur comprise entre 1 et 300 µm, voire entre 60 µm et 200 µm.

En outre, l'espacement entre deux cellules photovoltaïques voisines, ou encore consécutives ou adjacentes, peut être supérieur ou égal à 1 mm, notamment compris entre 1 et 30 mm, et de préférence égal à 3 mm.

De plus, l'invention a encore pour objet, selon un autre de ses aspects, un procédé de fabrication d'un dispositif photovoltaïque tel que défini précédemment, caractérisé en ce qu'il comporte l'étape d'assemblage de ladite au moins une couche de revêtement sur le ou les modules photovoltaïques lors de leur fabrication, notamment par lamination des couches constitutives du ou des modules photovoltaïques, ou l'étape d'assemblage de ladite au moins une couche de revêtement sur le ou les modules photovoltaïques après leur fabrication, notamment en la rapportant sur le ou les modules photovoltaïques et la fixant, par exemple par collage.

Par ailleurs, l'invention a encore pour objet, selon un autre de ses aspects, un procédé d'utilisation d'un dispositif photovoltaïque tel que défini précédemment, caractérisé en ce qu'il comporte l'étape suivante :
- ponçage de ladite au moins une couche de revêtement après usure de celle-ci pour permettre d'en retrouver la fonctionnalité.

Le procédé peut en outre comporter l'étape suivante :
- structuration de ladite au moins une couche de revêtement par formation d'un motif en relief conférant à ladite au moins une couche de revêtement une rugosité.

Le procédé peut encore comporter l'étape suivante :
- dépôt d'au moins une couche fonctionnelle, notamment une couche d'accroche, antidérapante et/ou colorée, réalisée en un matériau différent de celui de ladite au moins une couche de revêtement, sur ladite au moins une couche de revêtement.

Le procédé peut par ailleurs comporter les étapes suivantes :
- ponçage de ladite au moins une couche de revêtement jusqu'à une épaisseur limite de celle-ci repérée par le biais dudit au moins un indicateur d'usure,
- dépôt d'une couche de revêtement supplémentaire sur ladite au moins une couche de revêtement.

Le dispositif photovoltaïque, le procédé de fabrication et le procédé d'utilisation selon l'invention peuvent comporter l'une quelconque des caractéristiques précédemment énoncées, prises isolément ou selon toutes combinaisons techniquement possibles avec d'autres caractéristiques.

### BRÈVE DESCRIPTION DES DESSINS

L'invention pourra être mieux comprise à la lecture de la description détaillée qui va suivre, d'exemples de mise en œuvre non limitatifs de celle-ci, ainsi qu'à l'examen des figures, schématiques et partielles, du dessin annexé, sur lequel :
- la figure 1 représente, en coupe, un exemple classique de module photovoltaïque comportant des cellules photovoltaïques cristallines,
- la figure 2 représente, en vue éclatée, le module photovoltaïque de la figure 1,
- la figure 3 illustre, en coupe, un premier exemple de réalisation d'un dispositif photovoltaïque conforme à l'invention comportant un unique module photovoltaïque,
- la figure 4 illustre, en coupe, l'exemple de réalisation de la figure 3, la couche de revêtement étant structurée,
- la figure 5 illustre, en coupe, différentes étapes a) à i) d'utilisation du dispositif photovoltaïque de la figure 3,
- la figure 6 illustre, en coupe, différentes étapes a) à c) d'utilisation d'un deuxième exemple de réalisation d'un dispositif photovoltaïque conforme à l'invention comportant trois modules photovoltaïques séparés entre eux par des espaces de séparation,
- la figure 7 illustre, en coupe, différentes étapes a) à d) de fabrication d'un troisième exemple de réalisation d'un dispositif photovoltaïque conforme à l'invention comportant un unique module photovoltaïque,
- la figure 8 illustre, en coupe, différentes étapes a) à d) d'utilisation d'un quatrième exemple de réalisation d'un dispositif photovoltaïque conforme à l'invention comportant un unique module photovoltaïque et deux indicateurs d'usure,
- la figure 9 illustre, en coupe, différentes étapes a) à c) d'utilisation d'un cinquième exemple de réalisation d'un dispositif photovoltaïque conforme à l'invention comportant trois modules photovoltaïques séparés entre eux par des espaces de séparation et deux indicateurs d'usure par module photovoltaïque,
- la figure 10 illustre, en coupe, différentes étapes a) à c) d'utilisation d'un sixième exemple de réalisation d'un dispositif photovoltaïque conforme à l'invention comportant trois modules photovoltaïques séparés entre eux par des espaces de séparation et un indicateur d'usure dans chaque espace de séparation, et
- la figure 11 illustre, en coupe, différentes étapes a) à d) d'utilisation d'un septième exemple de réalisation d'un dispositif photovoltaïque conforme à l'invention comportant un unique module photovoltaïque et une couche fonctionnelle.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Les figures 1 et 2 ont déjà été décrites dans la partie relative à l'état de la technique antérieure.

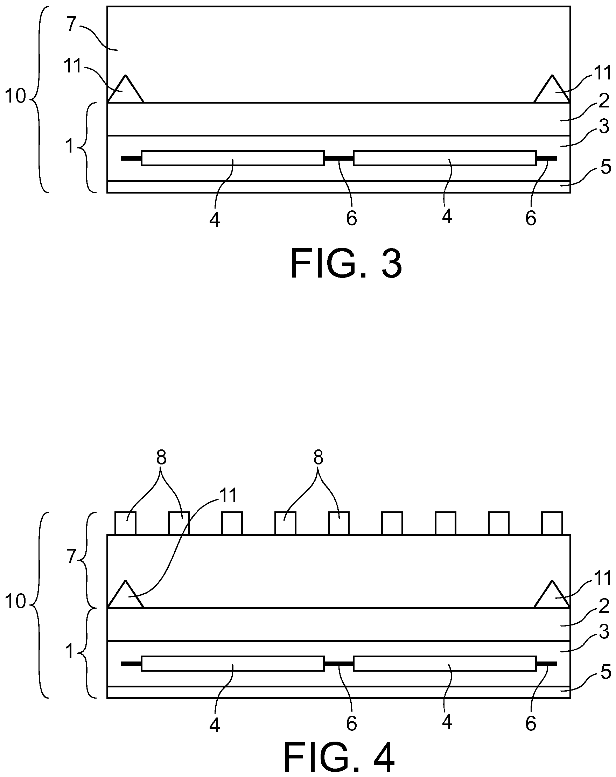

Les figures 3 à 11 illustrent, en coupe, plusieurs modes de réalisation d'un dispositif photovoltaïque 10 conforme à l'invention.

Pour chacun de ces modes de réalisation, on considère que les cellules photovoltaïques 4, interconnectées par des rubans 6 en cuivre étamé soudés, sont des cellules « cristallines », c'est-à-dire qui sont à base de silicium mono ou multicristallin, et qu'elles présentent une épaisseur comprise entre 1 et 300 µm, voire entre 60 µm et 200 µm.

De plus, l'ensemble encapsulant 3 est choisi pour être réalisé à partir de deux couches de poly(éthylène-acétate de vinyle) (EVA) entre lesquelles sont disposées les cellules photovoltaïques 4, chaque couche étant d'épaisseur minimale égale à 300 µm, voire 200 µm. En variante, cet ensemble encapsulant 3 peut aussi être un élastomère thermoplastique. Le cas échéant, l'une ou les deux couches formant l'ensemble encapsulant 3 peuvent être colorées.

Tout d'abord, un premier exemple de réalisation va être décrit en référence aux figures 3 à 5.

Comme visible sur la figure 3, le dispositif photovoltaïque 10 comporte un module photovoltaïque 1. Celui-ci comprend une première couche 2 transparente formant la face avant du module photovoltaïque 1, destinée à recevoir un flux lumineux, par exemple en verre ou en polymère, une pluralité de cellules photovoltaïques 4 disposées côte à côte et reliées électriquement entre elles par des rubans 6, un ensemble encapsulant 3 la pluralité de cellules photovoltaïques 4, et une deuxième couche 5 formant la face arrière du module photovoltaïque 1, par exemple en polymère ou en composite.

Ce type de module photovoltaïque 1 peut être utilisé dans des applications contraignantes susceptibles d'endommager la face avant du module 1 et d'impacter son efficacité en empêchant la réception du flux lumineux. Par exemple, le module photovoltaïque 1 peut être employé sur un pont de bateau. Dans ce cas, on utilisera un module léger et flexible. Toutefois, le module sera soumis à une usure fréquente. Il peut encore être utilisé pour une route solaire et alors la face avant sera formée par exemple d'une plaque polymère de plusieurs millimètres d'épaisseur, laquelle sera aussi soumis à une usure inévitable. Dans ces applications entraînant une usure de la face avant du module, il est souhaitable d'utiliser un revêtement, par exemple antidérapant (pont de bateau) ou d'accroche pour permettre l'adhérence (route solaire).

Ainsi, conformément à l'invention, le dispositif photovoltaïque 10 comporte une couche de revêtement 7 qui est disposée sur la première couche 2 du module photovoltaïque 1.

Avantageusement, cette couche de revêtement 7 est ponçable. Elle peut être réalisée en polymère ou en composite. Elle présente de bonnes propriétés optiques et se trouve au contact de la face avant 2 du module 1. Cette couche de revêtement 7 peut être teintée pour répondre à des besoins d'esthétisme par exemple. Elle peut être réalisée lors de la fabrication du module 1 ou bien alors être rapportée sur le module 1 une fois celui-ci installé sur son lieu d'utilisation.

La couche de revêtement 7 comporte deux indicateurs d'usure 11, chacun positionné sur la première couche 2 au niveau d'un bord de la première couche 2. Chaque indicateur d'usure 11 est par exemple de forme conique, sans que cela ne soit limitatif. De cette façon, un taux d'usure proportionnel à la surface d'une coupe transversale de la forme conique peut être repéré.

La figure 4 illustre la possibilité de structurer la couche de revêtement 7 pour notamment lui apporter une fonction d'accroche. Ainsi, la couche de revêtement 7 comporte un motif en relief 8 lui conférant une certaine rugosité.

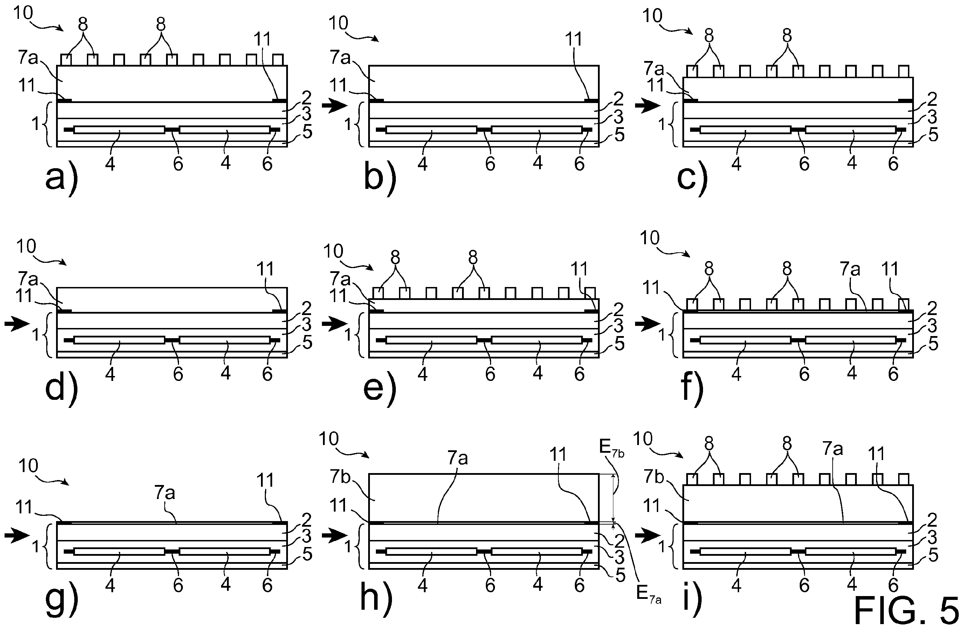

Par ailleurs, la figure 5 illustre, en coupe, différentes étapes a) à i) d'utilisation du dispositif photovoltaïque 10 de la figure 3.

En effet, lorsque la couche de revêtement 7 présente une usure ou lorsque la fonction du module photovoltaïque 1 de recevoir un flux lumineux n'est plus assurée, elle peut être poncée pour retrouver la fonction d'origine. Ainsi, une certaine quantité de matière peut être enlevée mais la protection du module 1 est toujours assurée. L'opération de ponçage peut être réalisée en plusieurs fois jusqu'à une limite d'usure maximale qui est fonction du module 1 ou de son application et qui est repérée par les indicateurs d'usure 11. Alors, une autre couche de revêtement peut être posée sur l'ancienne couche, et le procédé d'utilisation peut être réitéré indéfiniment.

Par exemple, dans l'étape a) de la figure 5, une première couche de revêtement 7a, structurée avec la présence d'un motif 8 en relief, est présente sur le module photovoltaïque 1. Dans l'étape b), à la suite d'une usure ou d'un non fonctionnement du module de l'étape a), la première couche de revêtement 7a a été poncée.

Dans l'étape c), la première couche de revêtement 7a a été poncée puis structurée de nouveau avec un motif en relief 8. Les étapes d), e) et f) illustrent d'autres étapes ultérieures avec ponçage et éventuellement restructuration à la suite d'une usure ou d'un non fonctionnement de la première couche de revêtement 7a.

Dans l'étape g), la première couche de revêtement 7a a atteint une épaisseur limite d'usure, repérée par la mise à nu des indicateurs d'usure 11, ce qui signifie qu'elle ne peut plus être poncée. Dans ce cas, comme illustré dans l'étape h), une deuxième couche de revêtement 7b est positionnée sur la première couche de revêtement 7a, au contact des indicateurs d'usure 11, laquelle peut à son tour être structurée comme illustré dans l'étape i). Dans cette deuxième couche de revêtement 7b, un ou plusieurs indicateurs d'usure 11, non représentés, peuvent aussi être prévus pour repérer un ponçage limite de la couche 7b. Cette possibilité s'applique à tous les modes de réalisation de l'invention. Toutefois, la plupart du temps, la deuxième couche de revêtement 7b sera poncée jusqu'aux indicateurs d'usure 11 de la première couche de revêtement 7a qui permettent de garantir l'intégrité du module photovoltaïque 1. Alors, une nouvelle couche de revêtement pourra être appliquée comme décrit précédemment.

Dans cet exemple, tout comme dans les exemples suivants, on remarque que l'épaisseur E₇ₐ de la première couche de revêtement 7a au-dessus de la première couche 2 du module photovoltaïque 1 est inférieure à l'épaisseur E_{7b} de la deuxième couche de revêtement 7b.

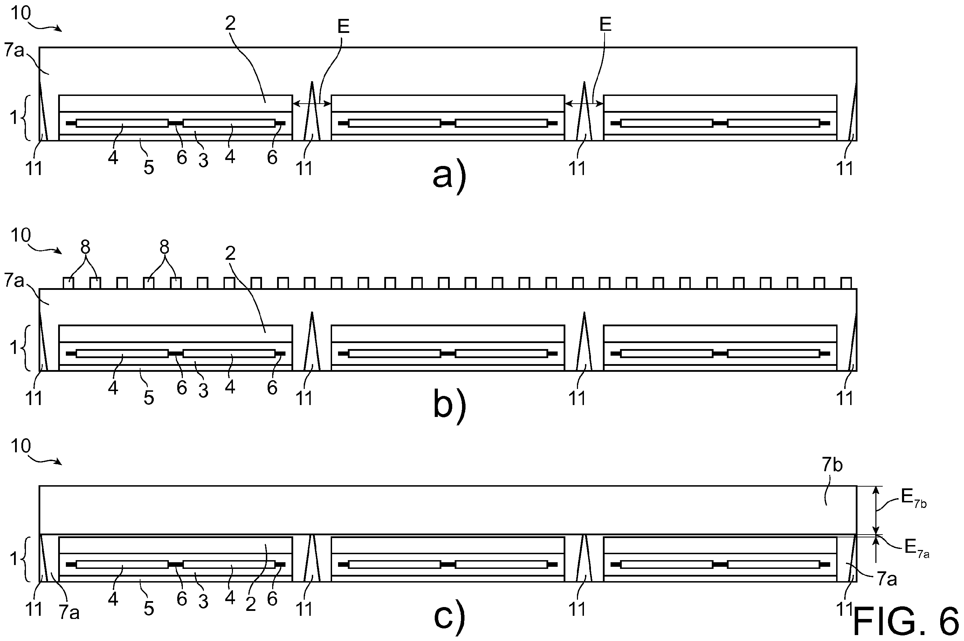

La figure 6 illustre, en coupe, différentes étapes a) à c) d'utilisation d'un deuxième exemple de réalisation d'un dispositif photovoltaïque 10 conforme à l'invention.

Dans cet exemple, le dispositif photovoltaïque 10 comporte trois modules photovoltaïques 1 séparés entre eux par des espaces de séparation E. De plus, des indicateurs d'usure 11, de forme conique, sont prévus des espaces de séparation E.

Plus précisément, dans l'étape a) de la figure 6, les trois modules photovoltaïques 1 sont recouverts par une première couche de revêtement 7a qui est disposée sur la première couche 2 de chaque module photovoltaïque 1 et dans les espaces de séparation E entre les modules photovoltaïques 1.

Dans l'étape b), cette première couche de revêtement 7a a été structurée avec un motif en relief 8.

Dans l'étape c), après une usure maximale obtenue de la première couche de revêtement 7a, repérée par l'apparition d'une section transversale des indicateurs d'usure 11 de forme conique correspondant à un pourcentage d'usure prédéterminé, une deuxième couche de revêtement 7b a été positionnée sur la première couche de revêtement 7a.

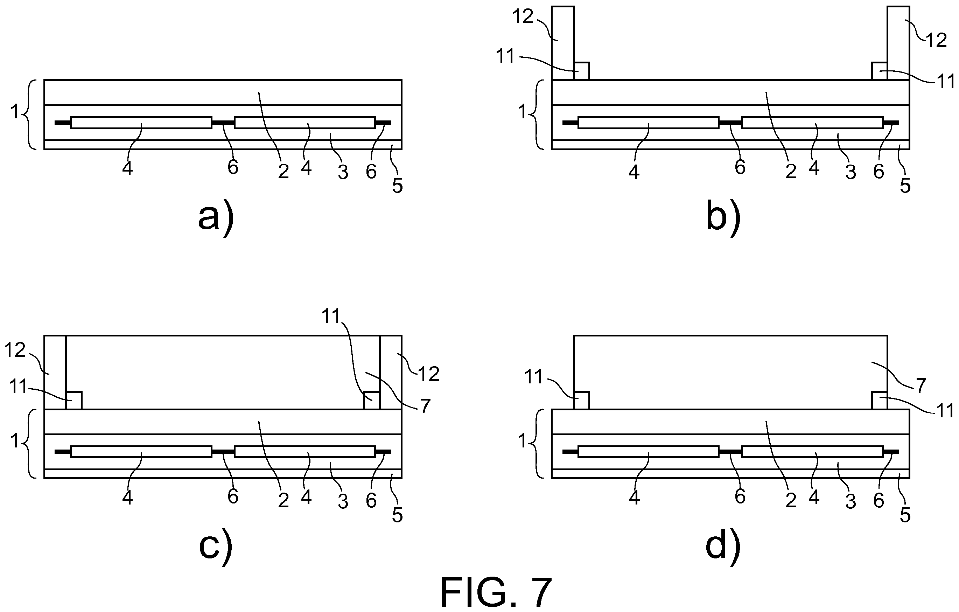

La figure 7 permet d'illustrer, en coupe, différentes étapes a) à d) de fabrication d'un troisième exemple de réalisation d'un dispositif photovoltaïque 10 conforme à l'invention comportant un unique module photovoltaïque 1.

Dans cet exemple, la couche de revêtement 7 utilisée comporte des matériaux polyuréthanes transparents qui, d'un point de vue optique, présentent l'avantage d'être transparents dans le domaine visible et celui proche de l'infrarouge (350-1100 nm). De plus, au niveau de l'indice de réfraction, celui-ci est généralement supérieur à 1,5 pour les polyuréthanes transparents. L'augmentation de cet indice jusqu'à environ 1,7 peut être possible en ajoutant des atomes de masse plus élevée dans la structure afin de la densifier. Par exemple, dans le cas des polyuréthanes, obtenus à partir de la réaction de fonction isocyanates -NCO avec des polyols -OH, cette augmentation d'indice peut se faire en utilisant un précurseur trithiol -SH à la place du polyol (remplacement des atomes d'oxygène par des atomes de soufre) pour obtenir des polythiouréthanes. Toutefois, il n'y a pas vraiment d'intérêt à augmenter l'indice du matériau au-delà de l'indice du matériau supérieur du module. Un verre a un indice proche de 1,5, et le matériau ponçable doit idéalement avoir un indice compris entre celui de l'air (un indice de 1) et celui du verre (un indice de 1,5). Si la face avant du module est composée d'un polymère d'indice 1,7, il y a un intérêt à utiliser une couche ponçable avec un indice compris entre 1 et 1,7.

Par ailleurs, d'un point de vue mécanique, le module élastique des polyuréthanes peut varier de quelques MPa à quelques GPa. L'ajustement de ce module provient du type de polyol utilisé. Un polyol à longue chaîne va donner un matériau très souple avec un module de l'ordre de quelques MPa alors qu'un polyol à courte chaîne va donner un polyuréthane plus rigide avec un module d'élasticité de quelques GPa.

En outre, d'un point de vue mécanique encore et de résistance aux chocs, cette couche de revêtement 7 peut avoir des propriétés élevées avec une densité faible, de l'ordre de 1,1 g/cm³, ce qui équivaut à 1,1 kg/m²/mm d'épaisseur. Cette valeur est plus de deux fois inférieure à celle d'un verre de même épaisseur.

Le module photovoltaïque 1 a été réalisé avec un dépôt d'une couche de revêtement 7 comprenant une résine polyuréthane, bi composant Cristal HRI 25 de Syntène®, le module comprenant quatre cellules photovoltaïques 4 (seules deux étant visibles sur la figure 7).

L'étape a) représente le module 1 avant l'ajout de la couche de revêtement 7. Au cours de l'étape b), des cales 12 d'environ 1 cm d'épaisseur, fixées à l'aide d'un adhésif de type PSA, sont placées sur la face avant 2 du module 1, par exemple en verre. De plus, au cours de cette étape b), des indicateurs d'usure 11 sont fixés, par exemple par collage, sur la première couche 2 du module 1.

Les composants de la résine formant la couche de revêtement 7 ont été mélangés dans les proportions indiquées par le fabricant Syntène®, à température et air ambiants, le mélange sous vide étant préféré. La résine a alors été versée directement sur la face avant 2, comme illustré à l'étape c). La réticulation s'est faite à température ambiante. L'étape d) correspond au retrait des cales 12 formant le cadre et l'obtention du dispositif photovoltaïque 10 conforme à l'invention.

Des essais de ponçage ont été réalisés, ainsi que des essais de dégradation par vandalisme de la couche de revêtement 7, entraînant des pertes optiques allant jusqu'à 56 % de courant Isc. Toutefois, la rénovation par ponçage de la couche de revêtement 7, puis dépôt d'une couche supplémentaire de revêtement a permis de retrouver les caractéristiques électriques initiales du module photovoltaïque 1.

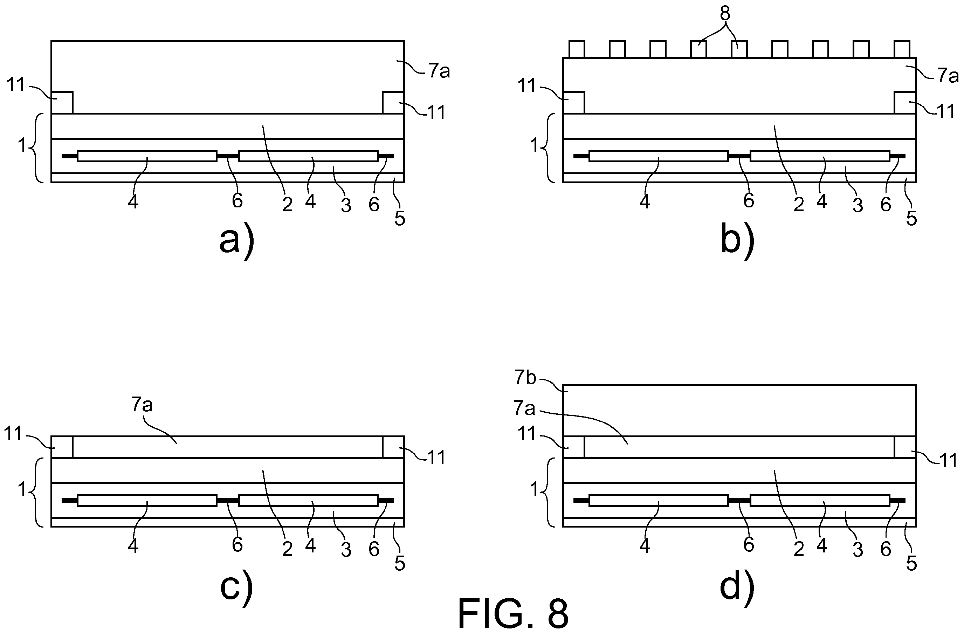

Les figures 8, 9 et 10 illustrent maintenant d'autres possibilités d'intégrer des indicateurs d'usure 11 dans la ou les couches de revêtements 7, 7a, 7b permettant de former des témoins limites de ponçage afin de ne pas atteindre un élément structurel du ou des modules photovoltaïques 1 lors du ponçage.

Ainsi, la figure 8 illustre, en coupe, différentes étapes a) à d) d'utilisation d'un quatrième exemple de réalisation d'un dispositif photovoltaïque 10 conforme à l'invention comportant un unique module photovoltaïque 1 et deux indicateurs d'usure 11.

Les indicateurs d'usure 11 sont distinguables visuellement au travers de la ou des couches de revêtement 7a, 7b de sorte à permettre de stopper le ponçage à l'approche de ces indicateurs.

Dans cet exemple, comme visible dans l'étape a) de la figure 8, un indicateur d'usure 11 est situé à chaque bord de la face avant 2, au contact de celle-ci, étant notamment collé à la face avant 2 par le biais d'un adhésif. De façon avantageuse, les indicateurs d'usure 11 ne sont pas superposés aux cellules photovoltaïques 4 de sorte à ne pas les ombrager.

L'épaisseur des indicateurs d'usure 11 est inférieure ou égale à l'épaisseur de la ou des couches de revêtements 7a, 7b.

Dans l'étape b), la première couche de revêtement 7a a été structurée avec un motif en relief 8. Dans l'étape c), le ponçage de la première couche de revêtement 7a a atteint sa limite en laissant apparaît les indicateurs d'usure 11 de sorte qu'une deuxième couche de revêtement 7b est déposée sur la première couche de revêtement 7a au cours de l'étape d).

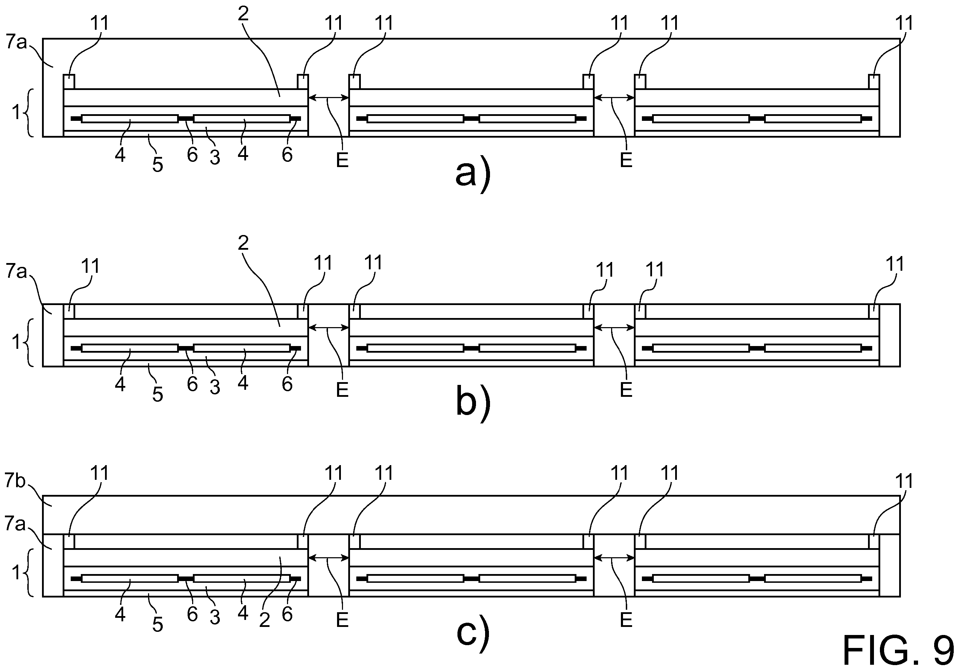

La figure 9 illustre encore, en coupe, différentes étapes a) à c) d'utilisation d'un cinquième exemple de réalisation d'un dispositif photovoltaïque 10 conforme à l'invention comportant cette fois-ci trois modules photovoltaïques 1 séparés entre eux par des espaces de séparation E et deux indicateurs d'usure 11 par module photovoltaïque 1.

Le principe est le même que celui de la figure 8 mais il est appliqué ici au cas d'un dispositif photovoltaïque 10 du type de la figure 6.

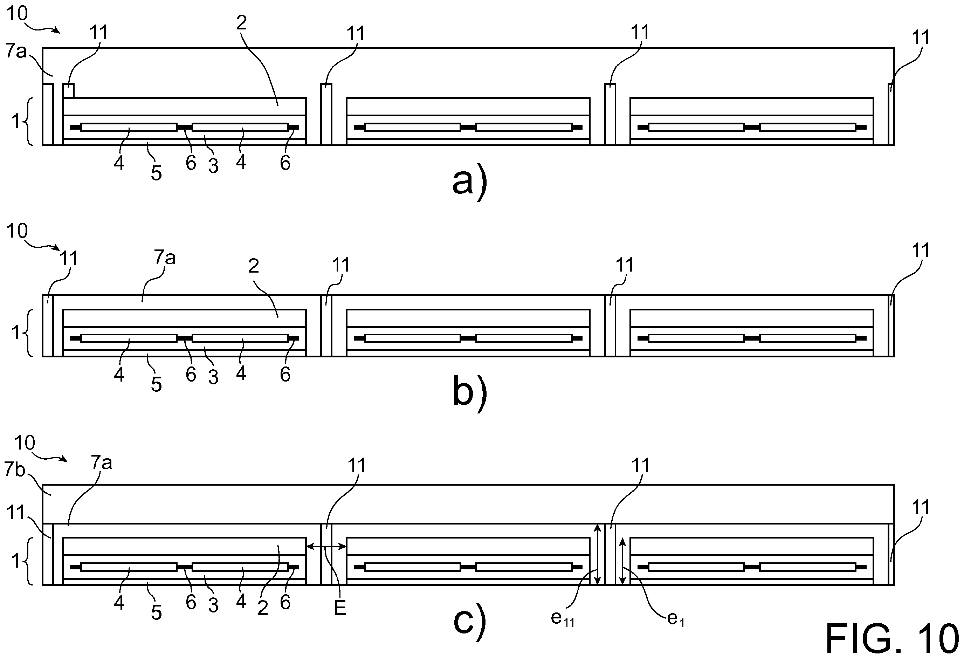

Par ailleurs, la figure 10 illustre, en coupe, différentes étapes a) à c) d'utilisation d'un sixième exemple de réalisation d'un dispositif photovoltaïque 10 conforme à l'invention comportant toujours trois modules photovoltaïques 1 séparés entre eux par des espaces de séparation E mais avec cette fois, un indicateur d'usure 11 dans chaque espace de séparation E. Ainsi, l'épaisseur e₁₁ des indicateurs d'usure 11 est supérieure à l'épaisseur e₁ des modules photovoltaïques 1.

Dans ces exemples précédemment décrits, les indicateurs d'usure 11 peuvent aussi être de forme conique.

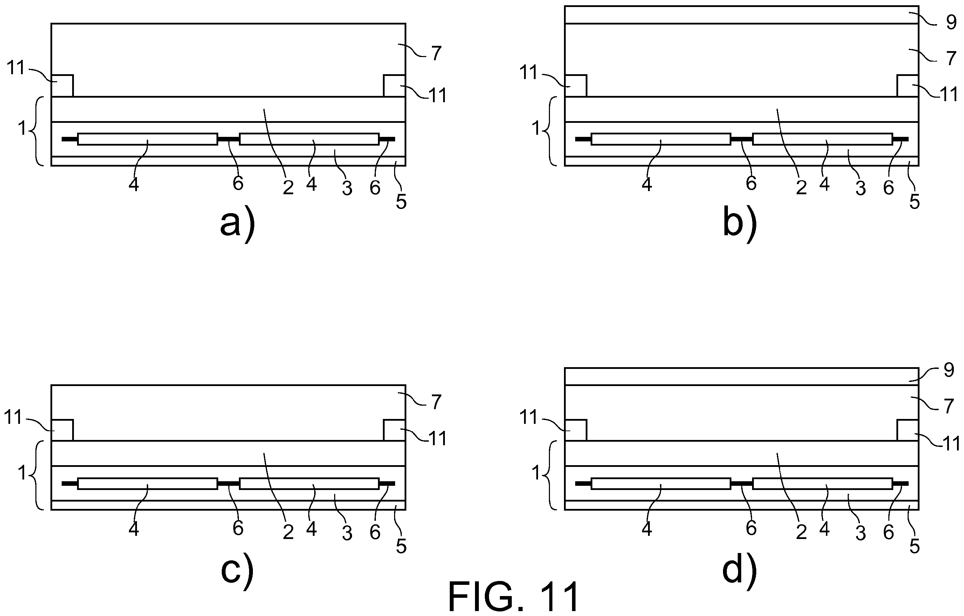

En outre, la figure 11 illustre, en coupe, différentes étapes a) à d) d'utilisation d'un septième exemple de réalisation d'un dispositif photovoltaïque 10 conforme à l'invention comportant un unique module photovoltaïque 1 et une couche fonctionnelle 9.

En effet, une couche fonctionnelle 9, notamment une couche d'accroche, antidérapante et/ou colorée, réalisée en un matériau différent de celui de la couche de revêtement 7, peut être appliquée sur celle-ci. Cette couche fonctionnelle 9 est disposée sur la couche de revêtement 7 alors située entre la couche fonctionnelle 9 et la première couche 2 du module photovoltaïque 1.

Cette couche fonctionnelle 9 peut constituer une couche sacrificielle, par exemple dans le cas d'une couche d'accroche pour une application sur route solaire. Cette couche fonctionnelle 9 peut alors être enlevée à chaque ponçage ou usinage pour structuration.

Dans tous les exemples de réalisation de l'invention, la ou les couches de revêtement 7, 7a, 7b présentent avantageusement des caractéristiques physiques et optiques accordées à celles du ou des modules photovoltaïques 1 afin de minimiser les pertes optiques et les contraintes thermomécaniques.

L'indice de réfraction optique peut être égal ou inférieur à celui de la face avant 2 d'un module photovoltaïque 1. La transparence optique dans le domaine 300-1300 nm est préférentiellement supérieure à 85 %, mieux 90 %. La résistance au choc est préférentiellement supérieure à 300 J/m. La dureté shore est élevée, par exemple supérieure à 80 Shore D. Le module est élastique en traction, supérieur à 1 GPa. La dilatation thermique est limitée avec un coefficient de dilatation thermique (CTE) inférieur à 200.10⁻⁶ K⁻¹, et idéalement le plus faible possible. Elle(s) présente(nt) de plus une stabilité thermique et aux ultraviolets sur la plage d'utilisation, et une adhésion avec les autres couches de revêtement.

De façon préférentielle, la ou les couches de revêtements 7, 7a, 7b comportent un matériau rigide, comme un matériau thermodurcissable, par exemple de la famille des polyuréthanes, acryliques et/ou époxys. Les polyuréthanes et les acryliques sont préférentiels en termes de transparence optique et de stabilité aux ultraviolets.

Bien entendu, l'invention n'est pas limitée aux exemples de réalisation qui viennent d'être décrits. Diverses modifications peuvent y être apportées par l'homme du métier.

## Revendications

1. Dispositif photovoltaïque (10), comportant :
- un ou plusieurs modules photovoltaïques (1), chaque module photovoltaïque (1) comportant :
- une première couche (2) transparente formant la face avant du module photovoltaïque (1), destinée à recevoir un flux lumineux,
- une pluralité de cellules photovoltaïques (4) disposées côte à côte et reliées électriquement entre elles,
- un ensemble encapsulant (3) la pluralité de cellules photovoltaïques (4),
- une deuxième couche (5) formant la face arrière du module photovoltaïque (1), l'ensemble encapsulant (3) et la pluralité de cellules photovoltaïques (4) étant situés entre les première (2) et deuxième (5) couches, le dispositif photovoltaïque (10) comportant
- au moins une couche de revêtement (7, 7a, 7b) disposée sur la première couche (2) du ou de chaque module photovoltaïque (1), la première couche (2) étant située entre ladite au moins une couche de revêtement (7, 7a, 7b) et l'ensemble encapsulant (3) la pluralité de cellules photovoltaïques (4), **caractérisé en ce que** le dispositif photovoltaïque (10) comporte au moins un élément d'indication de l'usure (11) de ladite au moins une couche de revêtement (7, 7a, 7b), permettent de renseigner sur l'épaisseur restante de la couche de revêtement, intégré dans ladite au moins une couche de revêtement (7, 7a, 7b) et visible au travers de ladite au moins une couche de revêtement (7, 7a, 7b).

2. Dispositif selon la revendication 1, **caractérisé en ce que** ledit au moins un élément d'indication d'usure (11) est positionné sur la première couche (2) du ou de chaque module photovoltaïque (1) au niveau d'un bord de la première couche (2).

3. Dispositif selon la revendication 1 ou 2, **caractérisé en ce qu'**il comporte au moins deux modules photovoltaïques (1), deux modules photovoltaïques (1) adjacents étant espacés l'un de l'autre par un espace de séparation (E), une ou plusieurs couches de revêtement (7, 7a, 7b) superposées étant disposée(s) sur la première couche (2) de chaque module photovoltaïque (1) et dans l'espace de séparation (E) entre deux modules photovoltaïques (1) adjacents, et **en ce que** ledit au moins un élément d'indication d'usure (11) est positionné dans le ou les espaces de séparation (E), l'épaisseur (e₁₁) dudit au moins un élément d'indication d'usure (11) étant supérieure à l'épaisseur (e₁) desdits au moins deux modules photovoltaïques (1).

4. Dispositif selon l'une des revendications précédentes, **caractérisé en ce que** ledit au moins un élément d'indication d'usure (11) est non superposé à une cellule photovoltaïque (4) pour éviter d'ombrager ladite cellule photovoltaïque (4).

5. Dispositif selon l'une quelconque des revendications précédentes, **caractérisé en ce que** ledit au moins un élément d'indication d'usure (11) est de forme conique.

6. Dispositif selon l'une quelconque des revendications précédentes, hormis la revendication 3, **caractérisé en ce qu'**il comporte un unique module photovoltaïque (1), une ou plusieurs couches de revêtement (7, 7a, 7b) superposées étant disposée(s) sur la première couche (2) du module photovoltaïque (1).

7. Dispositif selon l'une quelconque des revendications 1 à 6, hormis la revendication 3, **caractérisé en ce qu'**il comporte au moins deux modules photovoltaïques (1), deux modules photovoltaïques (1) adjacents étant espacés l'un de l'autre par un espace de séparation (E), une ou plusieurs couches de revêtement (7, 7a, 7b) superposées étant disposée(s) sur la première couche (2) de chaque module photovoltaïque (1) et dans l'espace de séparation (E) entre deux modules photovoltaïques (1) adjacents.

8. Dispositif selon l'une quelconque des revendications précédentes, **caractérisé en ce que** ladite au moins une couche de revêtement (7, 7a, 7b) est structurée, comportant un motif en relief (8) conférant à ladite au moins une couche de revêtement (7, 7a, 7b) une rugosité.

9. Dispositif selon l'une quelconque des revendications précédentes, **caractérisé en ce qu'**il comporte au moins une première couche de revêtement (7a) et une deuxième couche de revêtement (7b), la première couche de revêtement (7a) étant située entre la deuxième couche de revêtement (7b) et la première couche (2) du ou de chaque module photovoltaïque (1), l'épaisseur (E₇ₐ) de la première couche de revêtement (7a) au-dessus de la première couche (2) du ou de chaque module photovoltaïque (1) étant notamment inférieure à l'épaisseur (E_{7b}) de la deuxième couche de revêtement (7b).

10. Dispositif selon l'une quelconque des revendications précédentes, **caractérisé en ce qu'**il comporte en outre au moins une couche fonctionnelle (9), notamment une couche d'accroche, antidérapante et/ou colorée, réalisée en un matériau différent de celui de ladite au moins une couche de revêtement (7, 7a, 7b), ladite au moins une couche fonctionnelle (9) étant disposée sur ladite au moins une couche de revêtement (7, 7a, 7b), laquelle est alors située entre ladite au moins une couche fonctionnelle (9) et la ou les premières couches (2) du ou des modules photovoltaïques (1).

11. Procédé de fabrication d'un dispositif photovoltaïque (10) selon l'une quelconque des revendications précédentes, **caractérisé en ce qu'**il comporte l'étape d'assemblage de ladite au moins une couche de revêtement (7, 7a, 7b) sur le ou les modules photovoltaïques (1) lors de leur fabrication, notamment par lamination des couches constitutives du ou des modules photovoltaïques (1), ou l'étape d'assemblage de ladite au moins une couche de revêtement (7, 7a, 7b) sur le ou les modules photovoltaïques (1) après leur fabrication, notamment en la rapportant sur le ou les modules photovoltaïques (1) et la fixant, par exemple par collage.

12. Procédé d'utilisation d'un dispositif photovoltaïque (10) selon l'une quelconque des revendications 1 à 10, **caractérisé en ce qu'**il comporte l'étape suivante :
- ponçage de ladite au moins une couche de revêtement (7, 7a, 7b) après usure de celle-ci pour permettre d'en retrouver la fonctionnalité.

13. Procédé selon la revendication 12, **caractérisé en ce qu'**il comporte l'étape suivante :
- structuration de ladite au moins une couche de revêtement (7, 7a, 7b) par formation d'un motif en relief (8) conférant à ladite au moins une couche de revêtement (7, 7a, 7b) une rugosité.

14. Procédé selon l'une des revendications 12 et 13, **caractérisé en ce qu'**il comporte l'étape suivante :
- dépôt d'au moins une couche fonctionnelle (9), notamment une couche d'accroche, antidérapante et/ou colorée, réalisée en un matériau différent de celui de ladite au moins une couche de revêtement (7, 7a, 7b), sur ladite au moins une couche de revêtement (7, 7a, 7b).

15. Procédé selon l'une quelconque des revendications 12 à 14, **caractérisé en ce qu'**il comporte les étapes suivantes :
- ponçage de ladite au moins une couche de revêtement (7a) jusqu'à une épaisseur (E₇ₐ) limite de celle-ci repérée par le biais dudit au moins un élément d'indication d'usure (11),
- dépôt d'une couche de revêtement supplémentaire (7b) sur ladite au moins une couche de revêtement (7a).

## Patentansprüche

1. Photovoltaikvorrichtung (10), umfassend:
- ein oder mehrere Photovoltaikmodule (1), wobei jedes Photovoltaikmodul (1) umfasst:
- eine erste transparente Schicht (2), die die vordere Fläche des Photovoltaikmoduls (1) bildet und dazu ausgelegt ist, einen Lichtfluss zu empfangen,
- eine Mehrzahl von Photovoltaikzellen (4), die nebeneinander angeordnet und elektrisch miteinander verbunden sind,
- eine Anordnung (3), die die Mehrzahl von Photovoltaikzellen (4) einkapselt,
- eine zweite Schicht (5), die die hintere Fläche des Photovoltaikmoduls (1) bildet, wobei die Einkapselungsanordnung (3) und die Mehrzahl von Photovoltaikzellen (4) zwischen der ersten (2) und der zweiten (5) Schicht angeordnet sind,
wobei die Photovoltaikvorrichtung (10) wenigstens eine Beschichtungsschicht (7, 7a, 7b) umfasst, die auf der ersten Schicht (2) des oder jedes Photovoltaikmoduls (1) angeordnet ist, wobei die erste Schicht (2) zwischen der wenigstens einen Beschichtungsschicht (7, 7a, 7b) und der Anordnung (3) angeordnet ist, die die Mehrzahl von Photovoltaikzellen (4) einkapselt,
**dadurch gekennzeichnet, dass** die Photovoltaikvorrichtung (10) wenigstens ein Element (11) zur Anzeige des Verschleißes der wenigstens einen Beschichtungsschicht (7, 7a, 7b) umfasst, das es ermöglicht, sich über die verbleibende Dicke der Beschichtungsschicht zu informieren, das in die wenigstens eine Beschichtungsschicht (7, 7a, 7b) integriert und durch die wenigstens eine Beschichtungsschicht (7, 7a, 7b) hindurch sichtbar ist.

2. Vorrichtung nach Anspruch 1, **dadurch gekennzeichnet, dass** das wenigstens eine Verschleißanzeigeelement (11) auf der ersten Schicht (2) des oder jedes Photovoltaikmoduls (1) im Bereich eines Rands der ersten Schicht (2) positioniert ist.

3. Vorrichtung nach Anspruch 1 oder 2, **dadurch gekennzeichnet, dass** sie wenigstens zwei Photovoltaikmodule (1) umfasst, wobei zwei benachbarte Photovoltaikmodule (1) voneinander um einen Separationsabstand (E) beabstandet sind, wobei eine oder mehrere Beschichtungsschichten (7, 7a, 7b) überlagert auf der ersten Schicht (2) jedes Photovoltaikmoduls (1) und in dem Separationsabstand (E) zwischen zwei benachbarten Photovoltaikmodulen (1) angeordnet ist/sind, und dass das wenigstens eine Verschleißanzeigeelement (11) in dem oder den Separationsabstand/Separationsabständen (E) positioniert ist, wobei die Dicke (e₁₁) des wenigstens einen Verschleißanzeigeelements (11) größer ist als die Dicke (e₁) der wenigstens zwei Photovoltaikmodule (1).

4. Vorrichtung nach einem der vorhergehenden Ansprüche, **dadurch gekennzeichnet, dass** das wenigstens eine Verschleißanzeigeelement (11) einer Photovoltaikzelle (4) nicht überlagert ist, um eine Verschattung der Photovoltaikzelle (4) zu vermeiden.

5. Vorrichtung nach einem der vorhergehenden Ansprüche, **dadurch gekennzeichnet, dass** das wenigstens eine Verschleißanzeigeelement (11) eine konische Form hat.

6. Vorrichtung nach einem der vorhergehenden Ansprüche, ausgenommen Anspruch 3, **dadurch gekennzeichnet, dass** sie ein einziges Photovoltaikmodul (1) umfasst, wobei eine oder mehrere überlagerte Beschichtungsschichten (7, 7a, 7b) auf der ersten Schicht (2) des Photovoltaikmoduls (1) angeordnet ist/sind.

7. Vorrichtung nach einem der Ansprüche 1 bis 6, ausgenommen Anspruch 3, **dadurch gekennzeichnet, dass** sie wenigstens zwei Photovoltaikmodule (1) umfasst, wobei zwei benachbarte Photovoltaikmodule (1) voneinander um einen Separationsabstand (E) beabstandet sind, wobei eine oder mehrere Beschichtungsschichten (7, 7a, 7b) überlagert auf der ersten Schicht (2) jedes Photovoltaikmoduls (1) und in dem Separationsabstand (E) zwischen zwei benachbarten Photovoltaikmodulen (1) angeordnet ist/sind.

8. Vorrichtung nach einem der vorhergehenden Ansprüche, **dadurch gekennzeichnet, dass** die wenigstens eine Beschichtungsschicht (7, 7a, 7b) strukturiert ist und ein Reliefmotiv (8) umfasst, das der wenigstens einen Beschichtungsschicht (7, 7a, 7b) eine Rauigkeit verleiht.

9. Vorrichtung nach einem der vorhergehenden Ansprüche, **dadurch gekennzeichnet, dass** sie wenigstens eine erste Beschichtungsschicht (7a) und eine zweite Beschichtungsschicht (7b) umfasst, wobei die erste Beschichtungsschicht (7a) zwischen der zweiten Beschichtungsschicht (7b) und der ersten Schicht (2) des oder jedes Photovoltaikmoduls (1) angeordnet ist, wobei die Dicke (E₇ₐ) der ersten Beschichtungsschicht (7a) über der ersten Schicht (2) des oder jedes Photovoltaikmoduls (1) insbesondere kleiner ist als die Dicke (E_{7b}) der zweiten Beschichtungsschicht (7b).

10. Vorrichtung nach einem der vorhergehenden Ansprüche, **dadurch gekennzeichnet, dass** sie ferner wenigstens eine funktionale Schicht (9) umfasst, insbesondere eine Kopplungs-, Antirutsch- und/oder gefäbte Schicht, die aus einem Material hergestellt ist, das von jenem der wenigstens einen Beschichtungsschicht (7, 7a, 7b) verschieden ist, wobei die wenigstens eine funktionale Schicht (9) auf der wenigstens einen Beschichtungsschicht (7, 7a, 7b) angeordnet ist, welche folglich zwischen der wenigstens einen funktionalen Schicht (9) und der oder den ersten Schicht(en) (2) des oder der Photovoltaikmodul(e) (1) angeordnet ist.

11. Verfahren zur Herstellung einer Photovoltaikvorrichtung (10) nach einem der vorhergehenden Ansprüche, **dadurch gekennzeichnet, dass** es einen Schritt des Zusammenfügens der wenigstens einen Beschichtungsschicht (7, 7a, 7b) auf dem oder den Photovoltaikmodul(en) (1) während ihrer Herstellung umfasst, insbesondere durch Laminieren der Schichten, aus denen das oder die Photovoltaikmodul(e) (1) besteht, oder den Schritt des Zusammenfügens der wenigstens einen Beschichtungsschicht (7, 7a, 7b) auf dem oder den Photovoltaikmodul(en) (1) nach ihrer Herstellung, insbesondere indem sie auf das oder die Photovoltaikmodul(e) (1) übertragen und befestigt wird, beispielsweise durch Kleben.

12. Verfahren zur Verwendung einer Photovoltaikvorrichtung (10) nach einem der Ansprüche 1 bis 10, **dadurch gekennzeichnet, dass** es den folgenden Schritt umfasst:
- Glätten der wenigstens einen Beschichtungsschicht (7, 7a, 7b) nach dem Verschleiß derselben, um eine Wiederherstellung ihrer Funktionalität zu ermöglichen.

13. Verfahren nach Anspruch 12, **dadurch gekennzeichnet, dass** es den folgenden Schritt umfasst:
- Strukturieren der wenigstens einen Beschichtungsschicht (7, 7a, 7b) durch Bilden eines Reliefmotivs (8), das der wenigstens einen Beschichtungsschicht (7, 7a, 7b) eine Rauigkeit verleiht.

14. Verfahren nach einem der Ansprüche 12 und 13, **dadurch gekennzeichnet, dass** es den folgenden Schritt umfasst:
- Aufbringen wenigstens einer funktionalen Schicht (9), insbesondere einer Kopplungs, -Antirutsch- und/oder gefärbten Schicht, die aus einem Material hergestellt ist, das von jenem der wenigstens einen Beschichtungsschicht (7, 7a, 7b) verschieden ist, auf der wenigstens einen Beschichtungsschicht (7, 7a, 7b).

15. Verfahren nach einem der Ansprüche 12 bis 14, **dadurch gekennzeichnet, dass** es die folgenden Schritte umfasst:
- Glätten der wenigstens einen Beschichtungsschicht (7a) bis zu einer Grenzdicke (E₇ₐ) derselben, die mittels des wenigstens einen Verschleißanzeigeelements (11) ermittelt wird,
- Aufbringen einer zusätzlichen Beschichtungsschicht (7b) auf der wenigstens einen Beschichtungsschicht (7a)

## Claims

1. A photovoltaic device (10), including:
- one or more photovoltaic modules (1), each photovoltaic module (1) including:
- a first transparent layer (2) forming the front face of the photovoltaic module (1), intended to receive a light flux,
- a plurality of photovoltaic cells (4) disposed side by side and electrically connected to each other,
- an assembly (3) encapsulating the plurality of photovoltaic cells (4),
- a second layer (5) forming the rear face of the photovoltaic module (1), the encapsulating assembly (3) and the plurality of photovoltaic cells (4) being located between the first (2) and second (5) layers,
the photovoltaic device (10) including at least one coating layer (7, 7a, 7b) disposed on the first layer (2) of the or each photovoltaic module (1), the first layer (2) being located between said at least one coating layer (7, 7a, 7b) and the assembly (3) encapsulating the plurality of photovoltaic cells (4),
**characterised in that** the photovoltaic device (10) includes at least one element (11) for indicating the wear of said at least one coating layer (7, 7a, 7b), allow information on the remaining thickness of the coating layer, integrated in said at least one coating layer (7, 7a, 7b) and visible through said at least one coating layer (7, 7a, 7b).

2. The device according to claim 1, **characterised in that** said at least one wear indicator element (11) is positioned on the first layer (2) of the or each photovoltaic module (1) at an edge of the first layer (2).

3. The device according to claim 1 or 2, **characterised in that** it includes at least two photovoltaic modules (1), two adjacent photovoltaic modules (1) being spaced from one another by a separation space (E), one or more superimposed coating layers (7, 7a, 7b) being disposed on the first layer (2) of each photovoltaic module (1) and in the separation space (E) between two adjacent photovoltaic modules (1), and **in that** said at least one wear indicator element (11) is positioned in the separation space(s) (E), the thickness (e₁₁) of said at least one wear indicator element (11) being greater than the thickness (e₁) of said at least two photovoltaic modules (1).

4. The device according to one of the preceding claims, **characterised in that** said at least one wear indicator element (11) is not superimposed on a photovoltaic cell (4) to avoid shading said photovoltaic cell (4).

5. The device according to any one of the preceding claims, **characterised in that** said at least one wear indicator element (11) is of conical shape.

6. The device according to any one of the preceding claims, apart from claim 3, **characterised in that** it includes a single photovoltaic module (1), one or more superimposed coating layers (7, 7a, 7b) being disposed on the first layer (2) of the photovoltaic module (1).

7. The device according to any one of claims 1 to 6, apart from claim 3, **characterised in that** it includes at least two photovoltaic modules (1), two adjacent photovoltaic modules (1) being spaced from one another by a separation space (E), one or more superimposed coating layers (7, 7a, 7b) being disposed on the first layer (2) of each photovoltaic module (1) and in the separation space (E) between two adjacent photovoltaic modules (1).

8. The device according to any one of the preceding claims, **characterised in that** said at least one coating layer (7, 7a, 7b) is structured, including a relief pattern (8) giving said at least one coating layer (7, 7a, 7b) a roughness.

9. The device according to any one of the preceding claims, **characterised in that** it includes at least a first coating layer (7a) and a second coating layer (7b), the first coating layer (7a) being located between the second coating layer (7b) and the first layer (2) of the or each photovoltaic module (1), the thickness (E₇ₐ) of the first coating layer (7a) above the first layer (2) of the or each photovoltaic module (1) being in particular less than the thickness (E_{7b}) of the second coating layer (7b).

10. The device according to any one of the preceding claims, **characterised in that** it further includes at least one functional layer (9), in particular a grip, non-slip and/or coloured layer, made of a material different from that of said at least one coating layer (7, 7a, 7b), said at least one functional layer (9) being disposed on said at least one coating layer (7, 7a, 7b), which is then located between said at least one functional layer (9) and the first layer(s) (2) of the photovoltaic module(s) (1).

11. A method for manufacturing a photovoltaic device (10) according to any one of the preceding claims, **characterised in that** it includes the step of assembling said at least one coating layer (7, 7a, 7b) on the photovoltaic module(s) (1) during their manufacture, in particular by lamination of the layers constituting the photovoltaic module(s) (1), or the step of assembling said at least one coating layer (7, 7a, 7b) on the photovoltaic module(s) (1) after their manufacture, in particular by adding it onto the photovoltaic module(s) (1) and fixing it, for example by gluing.

12. A method for using a photovoltaic device (10) according to any one of claims 1 to 10, **characterised in that** it includes the following step:
- sanding said at least one coating layer (7, 7a, 7b) after wear thereof to allow its functionality to be recovered.

13. The method according to claim 12, **characterised in that** it includes the following step:
- structuring said at least one coating layer (7, 7a, 7b) by forming a relief pattern (8) giving said at least one coating layer (7, 7a, 7b) a roughness.

14. The method according to one of claims 12 and 13, **characterised in that** it includes the following step:
- depositing at least one functional layer (9), in particular a grip, non-slip and/or coloured layer, made of a material different from that of said at least one coating layer (7, 7a, 7b), on said at least one coating layer (7, 7a, 7b).

15. The method according to any one of claims 12 to 14, **characterised in that** it includes the following steps:
- sanding said at least one coating layer (7a) to a limit thickness (E₇ₐ) thereof identified by means of said at least one wear indicator element (11),
- depositing an additional coating layer (7b) on said at least one coating layer (7a).
